## Europäisches Patentamt

## European Patent Office

## Office européen des brevets

Veröffentlichungsnummer: **0 284 657**

**A2**

(12) **EUROPÄISCHE PATENTANMELDUNG**

(21) Anmeldenummer: 87116482.8

(22) Anmeldetag: 07.11.87

(51) Int. Cl.⁴ **C30B 23/02** , C30B 29/48

(30) Priorität: 30.03.87 DE 3710497

(43) Veröffentlichungstag der Anmeldung:
05.10.88 Patentblatt 88/40

(84) Benannte Vertragsstaaten:
AT BE CH DE ES FR GB GR IT LI NL SE

(71) Anmelder: **TZN Forschungs- und
Entwicklungszentrum Unterlüss GmbH
Neuensothrither Strasse 20
3104 Unterlüss(DE)**

(72) Erfinder: **Neff, Franz Helmut, Dr.
Backebergsmühle 11
D-3102 Hermannsburg(DE)**

(74) Vertreter: **Podszus, Burghart, Dipl.-Phys.
Rheinmetall GmbH Ulmenstrasse 125
Postfach 6609
D-4000 Düsseldorf(DE)**

(54) **Verfahren und Vorrichtung zur Herstellung von dünnen, aus mehreren elementaren Komponenten bestehenden Filmen.**

㊗ Zur Herstellung von dünne, aus mehreren elementaren Komponenten bestehenden Filmen (20), die auf einem Substrat(8) epitaktisch im Vakuum aufgebracht werden, erfolgt zunächst eine Zerstäubung des die elementaren Komponenten enthaltenden Materials.

Um zu erreichen, daß die Filme eine möglichst homogene Zusammensetzung aufweisen und die Herstellung für eine Großserienfertigung geeignet ist, wird vorgeschlagen, die einzelnen elementaren Komponenten jeweils auf einem separaten Target (9, 10, 11) anzuordnen und die elementaren Komponenten mit Hilfe einer entsprechenden Anzahl von Ionenstrahlen (17, 18, 19), die auf das jeweilige Target (9, 10, 11) gerichtet sind, gleichzeitig abzustäuben, wobei die genaue Zusammensetzung des auf dem Substrat (8) entstehenden Filmes (20) durch Regelung der Stromstärke der Ionenstrahlen (17, 18, 19) erfolgt.

FIG.1

# Verfahren und Vorrichtung zur Herstellung von dünnen, aus mehreren elementaren Komponenten bestehenden Filmen

Die Erfindung bezieht sich auf Verfahren zur Herstellung von dünnen, aus mehreren elementaren Komponenten bestehenden Filmen gemäß den Merkmalen des Oberbegriffs des Anspruchs 1. Ferner betrifft die Erfindung Vorrichtungen zur Durchführung derartiger Verfahren.

Zur Herstellung von dünnen Filmen aus mehreren elementaren Komponenten, z. B. von Filmen, die aus Cadmium-Quecksilber-Tellurit bestehen, sind mehrere Verfahren bekannt. Beispielweise können solche Filme durch RF Kathodenzerstäubung (vgl. zum Beispiel H. Kraus u. a., Journal Electrochemical Society (1967) 616) mit Hilfe der Molekularstrahlepitaxie (vgl. zum Beispiel J. P. Faurie u. a.. Applied Physical Letter 45 (1984) 1307) und Filmdeposition (MOCDV) durch pyrolytische Zersetzung von metallorganischen Verbindungen (vgl. zum Beispiel W. E. Hoke und R. Traczewski. Journal Applied Physics 54 (1983) 5087) hergestellt werden.

Diese bekannten Verfahren besitzen aber verschiedene Nachteile:

So erlaubt die RF Kathodenzerstäubung keine ausreichende Kontrolle der Stoichiometrie aufgrund der unterschiedlichen Abstäubraten der einzelnen Elemente vom homogen zusammengesetzten Target.

Bei Verwendung der Molekularstrahlepitaxie ist insbesondere für die Herstellung von Cadmium-Quecksilber-Tellurit-Filmen ein sehr hoher apparativer Aufwand erforderlich. Die Substrattemperaturen für die Herstellung der Filme hoher Güte sind hoch. Der für eine Deposition notwendige Quecksilberdampfdruck ist hoch und schwierig zu kontrollieren.

Die Qualität der mittels MOCVD hergestellten Filme ist schwierig zu kontrollieren: So sind die kommerziell erhältlichen metallorganischen Verbindungen nicht mit gleichbleibender Qualität lieferbar und der Einsatz von Metallorganika erfordert umfangreiche Sicherheitsmaßnahmen.

Der vorliegenden Erfindung lag daher die Aufgabe zugrunde, ein Verfahren der eingangs erwähnten Art so weiterzuentwickeln, daß es einfach durchzuführen ist und für eine Großserienfertigung verwendet werden kann.

Diese Aufgabe wird erfindungsgemäß durch die Merkmale des kennzeichnenden Teil des Anspruchs 1 gelöst. Eine entsprechende Vorrichtung zur Durchführung des Verfahrens nach Anspruch 1 offenbart Anspruch 4. Weitere, besonders vorteilhafte Ausgestaltungen der Erfindung werden in den Unteransprüchen wiedergegeben.

Im folgenden wird ein Ausführungsbeispiel anhand von Zeichnungen näher erläutert.

Es zeigen:

Fig. 1 schematisch eine Vorrichtung zur Erzeugung dünner Cadmium-Quecksilber-Tellurit-Filme und

Fig. 2 eine Draufsicht auf die erfindungsgemäße Vorrichtung nach Fig. 1.

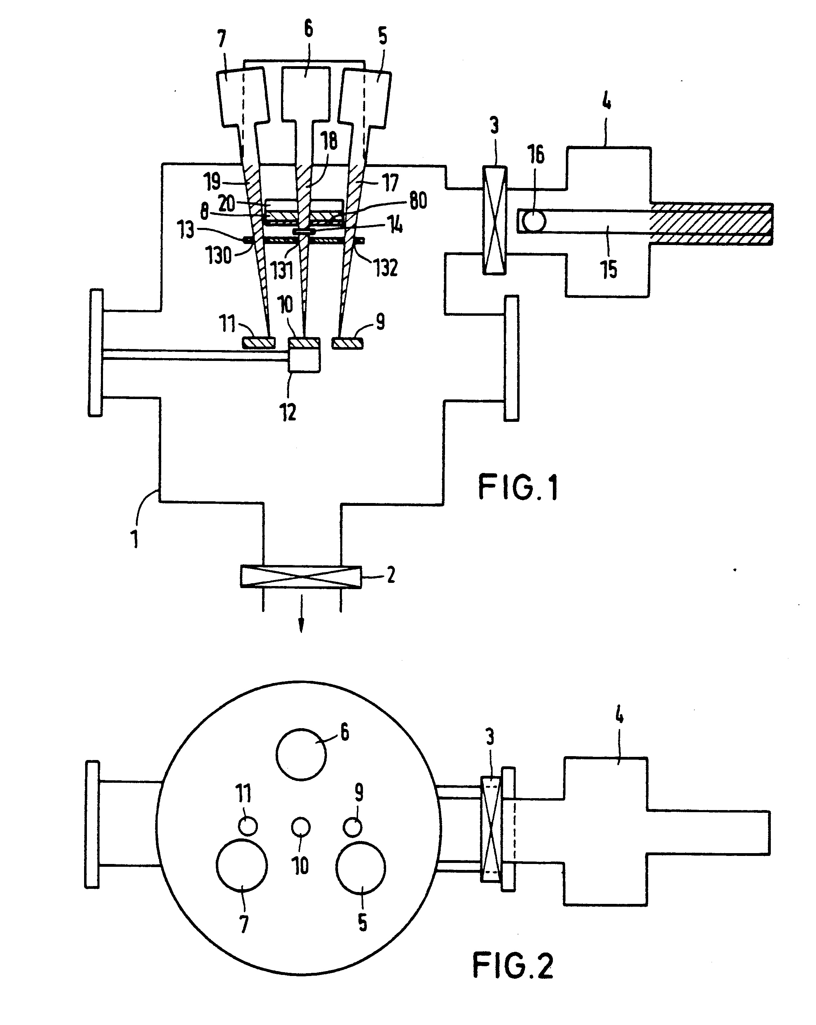

In Fig. 1 ist mit 1 eine Vakuumkammer bezeichnet, die über ein erstes Vakuumventil 2 mit einer nicht dargestellten Vakuumpumpe und über ein zweites Vakuumventil 3 mit einem Substrat Transfersystem 4 verbunden ist.

An der Vakuumkammer 1 sind drei mikroprozessorgesteuerte Argon-Ionenkanonen 5, 6 und 7 (z. B. der Fa. Kimball Physics Inc.) angeordnet. Innerhalb der Vakuumkammer 1 befinden sich sowohl ein Substrat 8 auf einem Substrathalter 80 als auch drei Targets 9, 10 und 11, auf denen sich das zu zerstäubende, noch reine Material, nämlich Quecksilber und Tellur befinden. Dabei ist unter dem Quecksilber-Target 10 eine Kühlvorrichtung 12 angeordnet, die bewirkt, daß das Quecksilber in seiner festen Phase vorliegt.

Zwischen den Targets 9, 10 und 11 und den Ionenquellen 5, 6 und 7 befindet sich eine Verschlußvorrichtung 13, mit der sichergestellt werden kann, daß der herzustellende dünne Film 20 erst dann auf das Substrat 8 aufgebracht wird, nachdem sich stationäre Betriebsbedingungen des Teilchenstromes des abgstäubten Materials eingestellt haben, so daß Inhomogenitäten im Film vermieden werden. Die Verschlußvorrichtung (13) ist daher so angeordnet, daß zwar das Substrat 8, nicht jedoch die Ionenstrahlen 17, 18, 19 abgedeckt werden. Hierzu weist die Vorrichtung 13 drei Öffnungen 130, 131 und 132 auf, durch die Ionnenstrahlen 17, 18, 19 hindurch und auf die Targets 9, 10, 11 gelangen.

Vorzugsweise kann unterhalb des Substrathalters 8 eine Sonde 14 angeordnet werden, mit der die Schichtdicke des auf dem Substrat sich ausbildenden Films bestimmt werden kann. Derartige Sonden sind bekannt und werden beispielsweise von der Fa. Leybold Heraeus verkauft (Schwingquarzmonitore). Sie sind mit einem in Fig. 1 nicht dargestellten Schichtdickenmeßgerät verbunden, welches außerhalb der Vakuumkammer 1 angeordnet ist.

Das Substrat-Transfer-System 4 enthält im wesentlichen einen zungenförmigen, längsverschiebbaren Träger 15, in dessen vorderem Ende ein neues Substrat 16 angeordnet ist.

Fig. 2 zeigt die Draufsicht auf die Vorrichtung nach Fig. 1. Dabei wurden für gleiche Teile gleiche Bezugszeichen verwendet.

Im folgenden wird kurz auf die Wirkungsweise der erfindungsgemäßen Vorrichtung sowie auf den Ablauf des erfindungsgemäßen Verfahrens eingegangen:

Nach Öffnen des zweiten Vakuumventils 3 wird mit Hilfe des Substrat-Transfer-Systems 4 das Substrat 16 in die Vakuumkammer 1 gebracht und auf dem Halter 8 angeordnet. Als Substrat eignet sich Saphir, CdTe, sowie Legierungen der Form CdZnTe oder CdTeSe. Das Substrat wird dann auf für kristallines Wachstum notwendige Temperatur erwärmt. Hierzu enthält der Substrathalter 8 eine nicht dargestellte Heizvorrichtung. Üblicherweise wird das Substrat auf eine Temperatur zwischen 70°C und 150°C erhitzt.

Nachdem das Substrat 8 auf die notwendige Temperatur erwärmt wurde, werden die Ionenquellen 5, 6 und 7 eingeschaltet, so daß die Ionenstrahlen 17, 18 und 19 auf die Targets 9, 10 und 11 treffen, die aus Cadmium, Quecksilber und Tellur bestehen. Nach Einstellung eines stationären Strahlstromes und Abstäubrate wird die Verschlußvorrichtung 13 geöffnet.

Die für ein stoichiometrisches Filmwachstum notwendigen Abstäubraten der einzelnen Elemente werden durch den Argon-Ionenstrom eingestellt. Hierzu wird eine unabhängige Kalibrierung durchgeführt, bei der der Teilchenstrom der abgestäubten elementaren Bestandteile als Funktion der Ionenenergie bestimmt wird.

Die Verschlußvorrichtung 13 wird solange geöffnet, bis die gewünschte Dicke des Filmes 20 erreicht ist. Dabei wird die Schichtdicke mit Hilfe der Sonde 14 bestimmt und an einem nicht dargestellten Meßgerät angezeigt. Anschließend wird die Verschlußvorrichtung 13 geschlossen und das Substrat mit Hilfe des Substrat-Transfer-Systems 4 entnommen.

## Ansprüche

1. Verfahren zur Herstellung von dünnen, aus mehreren elementaren Komponenten bestehenden Filmen (20), die auf einem Substrat (8) epitaktisch im Vakuum aufgebracht werden, wobei zunächst eine Zerstäubung des die elementaren Komponenten enthaltenden Materials erfolgt, **gekennzeichnet durch** folgende Merkmale:

a) die einzelnen elementaren Komponenten werden jeweils auf einem separaten Target (9, 10, 11) angeordnet;

b) die elementaren Komponenten werden mit Hilfe einer entsprechenden Anzahl von Ionenstrahlen (17, 18, 19), die auf das jeweilige Target (9, 10, 11) gerichtet sind, gleichzeitig abgestäubt;

c) die genaue Zusammensetzung des auf dem Substrat (8) entstehenden Filmes (20) wird durch Regelung der Stromstärke der Ionenstrahlen (17, 18, 19) eingestellt.

2. Verfahren zur Herstellung von dünnen Filmen nach Anspruch 1, **dadurch gekennzeichnet,** daß als Ionenquellen (5, 6, 7) Argon-Ionenquellen verwendet werden.

3. Verwendung des Verfahrens nach Anspruch 1 und 2 zur Herstellung dünner Filme aus Cadmium-Quecksilber-Tellurit.

4. Vorrichtung zur Durchführung des Verfahrens nach Anspruch 1, wobei im Inneren einer Vakuumkammer (1) eine Substrat Haltevorrichtung und Haltevorrichtungen für das zu zerstäubende Material vorgesehen sind, **gekennzeichnet durch** die Merkmale:

a) in der Vakuumkammer (1) sind genau soviel Haltevorrichtungen für die Targets (9, 10, 11) vorgesehen, wie es elementare Komponenten gibt;

b) an der Vakuumkammer (1) sind Ionenkanonen (5, 6, 7) derart angeordnet, daß jeweils eine Ionenkanone im Betrieb Ionen ausstrahlt, die jeweils genau auf ein Target (9, 10, 11) auftreffen.

5. Vorrichtung nach Anspruch 4, **dadurch gekennzeichnet,** daß eine Sonde (14) zur Messung der Schichtdicke des entstehenden Films (20) vorgesehen ist.

6. Vorrichtung nach Anspruch 4, **dadurch gekennzeichnet,** daß zwischen dem Substrathalter (80) und den Targets (9, 10, 11) eine Verschlußvorrichtung (13) angeordnet ist, die Öffnungen (130, 131, 132) aufweist, durch die die Ionenstrahlen (17, 18, 19) auf die Targets (9, 10, 11) gelangen.

FIG.1

FIG.2

Rheinmetall GmbH

TZN 2